# EUROPEAN PATENT APPLICATION

(11) **EP 4 723 838 A1**
(43) Date of publication of application: **08.04.2026**
(21) Application number: 24895690.6
(22) Date of filing: 26.07.2024
(51) Int. Cl.: H10F 10/14, H10F 71/00

(54) **TOPCON CELL, AND TOPCON CELL PREPARATION METHOD**

(30) Priority: 28.11.2023 CN 202311606504
(71) Applicant: CHINT New Energy Technology Co., Ltd., Haining, Zhejiang 314400 (CN)
(72) Inventor: YU, Hao, Jiaxing, Zhejiang 314400 (CN); CAI, Yongmei, Jiaxing, Zhejiang 314400 (CN); HE, Sheng, Jiaxing, Zhejiang 314400 (CN); HSU, Wei-Chih, Jiaxing, Zhejiang 314400 (CN)
(74) Representative: PGA S.p.A., Milano, Succursale di Lugano
(86) International application number: PCT/CN2024/107794
(87) International publication number: WO 2025/112587

(57) **Abstract**

A TOPCon cell and a TOPCon cell preparation method, which belong to the field of solar cells. The cell comprises a substrate, wherein a side surface of the substrate is provided with a laminated passivation film and an electrode, the laminated passivation film comprising a tunneling layer, a first doped polycrystalline silicon layer, a diffusion barrier layer and a second doped polycrystalline silicon layer, which are sequentially arranged in a direction facing away from the substrate; and the side surface of the substrate that faces the electrode has a metallized region and a non-metallized region, and the diffusion barrier layer corresponds to the non-metallized region for preventing doping elements in the second doped polycrystalline silicon layer from diffusing into the first doped polycrystalline silicon layer, such that the doping concentration of the first doped polycrystalline silicon layer in the non-metallized region is lower than the doping concentration of the first doped polycrystalline silicon layer in the metallized region. Two doped polycrystalline silicon layers are used, and a diffusion barrier layer is provided in a non-metallized region, such that the doping concentration of the inner doped polycrystalline silicon layer is reduced, thereby improving the passivation effect while ensuring an Auger recombination rate.

## Description

### CROSS REFERENCE TO RELATED APPLICATIONS

This application claims the priority of Chinese Patent Application No. 202311606504.3, filed with the China National Intellectual Property Administration on November 28, 2023, and titled with "TOPCON CELL, AND TOPCON CELL PREPARATION METHOD", which is hereby incorporated by reference in its entirety.

### FIELD

The present disclosure relates to the field of solar cell, especially relates to a TOPCon cell and TOPCon cell preparation method.

### BACKGROUND

In current industrial production of crystalline silicon TOPCon (Tunnel Oxide Passivated Contact) cells, a tunnel oxide layer and doped polysilicon stacked passivation structure are generally formed on a front surface, a rear surface, or both surfaces of the TOPCon cell. Wherein, the doped polysilicon is typically performed by depositing intrinsic amorphous silicon or in-situ doped amorphous silicon on a surface of a tunnel oxide layer of a crystalline silicon cell by chemical vapor deposition, followed by high-temperature treatment to convert the intrinsic amorphous silicon or the in-situ doped amorphous silicon into a microcrystalline or polysilicon thin-film layer.

To match the currently mature metallization paste printing technology in industrialization, screen-printing paste technology is generally used to form an ohmic contact with a passivation effect between the polysilicon thin-film layer and the electrode. First, in order to ensure a good ohmic contact between the electrode and the polysilicon thin-film layer, the polysilicon thin-film layer is commonly formed with a high doping concentration. To minimize the Auger recombination rate in the polysilicon thin-film layer as much as possible caused by the high doping concentration, it is generally necessary to reduce the thickness of the polysilicon thin-film layer as much as possible; however, reducing the thickness of the polysilicon thin-film layer will decrease its passivation performance. Second, due to the corrosive characteristics of current metallization pastes, particularly the strong corrosiveness of the glass phase in aluminum paste, the paste tends to penetrate the polysilicon thin-film layer during subsequent high-temperature sintering. The thickness of currently used polysilicon thin-film layers is generally controlled above 120 nm. Therefore, the thickness of the doped polysilicon thin-film layer needs to be optimized to achieve a balance between reducing the Auger recombination rate and improving passivation performance. Accordingly, how to enhance passivation performance while simultaneously reducing the Auger recombination rate is a technical problem that those skilled in the art urgently need to solve.

### SUMMARY

The objective of the present disclosure is to provide a TOPCon cell and a TOPCon cell preparation method, which can reduce the Auger recombination rate while simultaneously enhancing passivation performance, thereby enhancing the energy conversion efficiency of the cell.

To realize the above objective, the present disclosure provides a TOPCon cell comprising a substrate; wherein a stacked passivation film and an electrode are provided on a surface of a side of the substrate;
wherein the stacked passivation film comprises a tunnel layer, a first doped polysilicon layer, a diffusion barrier layer, and a second doped polysilicon layer sequentially arranged in a direction away from the substrate;
wherein a metallized region and a non-metallized region are provided on a surface of a side of the substrate facing the electrode, the diffusion barrier layer corresponds to the non-metallized region and is used to block diffusion of a doping element in the second doped polysilicon layer into the first doped polysilicon layer, such that doping concentration of the first doped polysilicon layer in the non-metallized region is lower than doping concentration of the first doped polysilicon layer in the metallized region.

Optionally, the diffusion barrier layer is a silicon oxide layer.

Optionally, the stacked passivation film is provided on the rear surface of the substrate, the first doped polysilicon layer and the second doped polysilicon layer adopt doping elements of the same type as the substrate, an overall doping concentration of the first doped polysilicon layer is greater than that of the substrate, and an overall doping concentration of the second doped polysilicon layer is greater than that of the first doped polysilicon layer.

Optionally, a rear passivation layer is provided on a surface of a side of the stacked passivation film away from the substrate, and the electrode passes through the rear passivation layer and is in contact with the stacked passivation film; wherein the rear passivation layer comprises at least one of SiNₓ film, SiOₓN_{y} film, Al₂O₃/SiNₓ stacked film, and SiOₓN_{y}/SiNₓ stacked film.

Optionally, the first doped polysilicon layer has a thickness of 20 nm to 40 nm, including the values at both ends;
wherein from a surface of the second doped polysilicon layer away from the substrate to a surface of the diffusion barrier layer away from the substrate has a thickness of 20 nm to 200 nm, including the values at both ends.

Optionally, the first doped polysilicon layer has an overall doping concentration of 1E19 cm⁻³ to 3E20 cm⁻³, including the values at both ends;
and the second doped polysilicon layer has an overall doping concentration of 5E20 cm⁻³ to 1E21 cm⁻³, including the values at both ends.

To realize the above objective, the present disclosure also provides a method for manufacturing a TOPCon cell comprising steps of:
forming a stacked passivation film layer on a surface of a side of a substrate; wherein the stacked passivation film comprises a tunnel layer, a first doped polysilicon layer, a diffusion barrier layer, and a second doped polysilicon layer sequentially arranged in a direction away from the substrate; wherein a metallized region and a non-metallized region are provided on a surface of a side of the substrate corresponding to the stacked passivation film layer, the diffusion barrier layer corresponds to the non-metallized region and is used to block diffusion of a doping element in the second doped polysilicon layer into the first doped polysilicon layer, such that doping concentration of the first doped polysilicon layer in the non-metallized region is lower than doping concentration of the first doped polysilicon layer in the metallized region.

Optionally, the step of forming the stacked passivation film layer on a surface of a side of the substrate comprises:
depositing a tunnel layer on a surface of the substrate;
depositing a first intrinsic amorphous silicon layer on a surface of the tunnel layer;
forming a diffusion barrier layer on a surface of the first intrinsic amorphous silicon layer corresponding to the non-metallized region;
depositing a second intrinsic amorphous silicon layer on a surface of the first intrinsic amorphous silicon layer corresponding to the metallized region and on a surface of the diffusion barrier layer; and
performing diffusion of a doping element, wherein in the metallized region, the doping element sequentially diffuses into the second intrinsic amorphous silicon layer and the first intrinsic amorphous silicon layer, and in the non-metallized region, the doping element sequentially diffuses into the second intrinsic amorphous silicon layer, the diffusion barrier layer, and the first intrinsic amorphous silicon layer, thereby converting the second intrinsic amorphous silicon layer into the second doped polysilicon layer and the first intrinsic amorphous silicon layer into the first doped polysilicon layer.

Optionally, after depositing the first intrinsic amorphous silicon layer on a surface of the tunnel layer, the method further comprises:
performing a light doping on the first intrinsic amorphous silicon layer.

Optionally, forming the stacked passivation film layer on the substrate comprises:
depositing the tunnel layer on a surface of the substrate;
depositing the first doped polysilicon layer on a surface of the tunnel layer by in-situ doping;
forming the diffusion barrier layer on a surface of the first doped polysilicon layer corresponding to the non-metallized region;
depositing the second doped polysilicon layer on a surface of the first doped polysilicon layer corresponding to the metallized region and on a surface of the diffusion barrier layer; and
performing annealing on the first doped polysilicon layer and the second doped polysilicon layer.

Apparently, the present disclosure provides a TOPCon cell adopting a double-layer doped polysilicon layer, which ensures that the thickness of the inner doped polysilicon layer can achieve a good passivation effect. Further, a diffusion barrier layer, corresponding to the non-metallized region, is added between the two doped polysilicon layers, and is used to block diffusion of a doping element of the outer doped polysilicon layer, thereby the inner doped polysilicon layer exhibits a high doping concentration in the metallized region and a low doping concentration in the non-metallized region. Consequently, the overall doping concentration of the inner doped polysilicon layer is reduced, thereby the Auger recombination rate is reduced. The doping concentration of the outer doped polysilicon layer is higher than that of the inner doped polysilicon layer. The inner doped polysilicon layer exhibits a high doping concentration in the metallized region, thereby ensuring the achievement of a good ohmic contact. The present disclosure further provides a method for manufacturing a TOPCon cell, and the TOPCon cell manufactured by this method exhibits the above advantageous effects.

### BRIEF DESCRIPTION OF DRAWINGS

To more clearly illustrate the technical solutions of the embodiments of the present disclosure or the conventional art, brief descriptions of the drawings required for the embodiments or the conventional art are provided below. It is apparent that the drawings described below are merely embodiments of the present disclosure. For a person skilled in the art, other drawings can be obtained based on the provided drawings without requiring inventive effort.
FIG. 1 is a structure of a TOPCon cell provided in an embodiment of the present disclosure.
FIG. 2 is a structure of a stacked passivation film on a metallized region provided in an embodiment of the present disclosure.
FIG. 3 is a structure of a stacked passivation film on a non-metallized region provided in an embodiment of the present disclosure.
FIG. 4 is a flowchart of a method for manufacturing a TOPCon cell provided in an embodiment of the present disclosure.
Fig. 5 is a structure of a TOPCon cell after texturing provided in an embodiment of the present disclosure.
Fig. 6 is a structure of a TOPCon cell after boron diffusion provided in an embodiment of the present disclosure.
Fig. 7 is a partially enlarged view of a TOPCon cell after boron diffusion provided in an embodiment of the present disclosure.
Fig. 8 is a structure of a TOPCon cell after removing BSG provided in an embodiment of the present disclosure.
Fig. 9 is a structure of a TOPCon cell after polishing provided in an embodiment of the present disclosure.
Fig. 10 is a structure of a TOPCon cell after patterning provided in an embodiment of the present disclosure.
Fig. 11 is a structure of a TOPCon cell after forming a stacked passivation film provided in an embodiment of the present disclosure.
Fig. 12 is a structure of a TOPCon cell after phosphorus diffusion provided in an embodiment of the present disclosure.
Fig. 13 is a curve diagram illustrating the variation of doping concentration with thickness provided in an embodiment of the present disclosure.
Fig. 14 is a structure of a TOPCon cell after forming a front passivation film and a rear passivation film provided in an embodiment of the present disclosure.

Reference numerals are described as follows:
1 - substrate/crystalline silicon substrate; 1a - first surface; 1b - second surface; 11a - doped layer/P-type doped layer; 11a' - BSG layer; 13 - stacked passivation film; 131 - tunnel silicon oxide layer; 132 - first doped polysilicon layer/first intrinsic amorphous silicon layer; 1321 - first high passivation silicon-containing layer; 1322 - first low passivation silicon-containing layer; 133 - diffusion barrier layer; 134 - second doped polysilicon layer/second intrinsic amorphous silicon layer; 14 - PSG layer; 151 - rear passivation layer; 152 - front passivation layer; 161 - rear electrode; 162 - front electrode.

### DETAILED DESCRIPTION

To make the objectives, technical solutions, and advantages of the embodiments of the present disclosure clearer, the technical solutions of the embodiments are described in detail below with reference to the accompanying drawings of the embodiments. It is apparent that the embodiments described are only part of the embodiments of the present disclosure rather than all embodiments. All other embodiments obtained by a person skilled in the art based on the embodiments of the present disclosure without requiring inventive effort fall within the scope of protection of the present disclosure.

In an embodiment of the present disclosure, a TOPCon cell is provided, which can comprise a substrate; and a stacked passivation film and an electrode are provided on a surface of a side of the substrate;
wherein the stacked passivation film comprises a tunnel layer, a first doped polysilicon layer, a diffusion barrier layer, and a second doped polysilicon layer sequentially arranged in a direction away from the substrate; and
wherein a metallized region and a non-metallized region are provided on a surface of a side of the substrate facing the electrode, the diffusion barrier layer corresponds to the non-metallized region and is used to block diffusion of a doping element in the second doped polysilicon layer into the first doped polysilicon layer, such that doping concentration of the first doped polysilicon layer in the non-metallized region is lower than doping concentration of the first doped polysilicon layer in the metallized region.

The present embodiment does not limit the specific types of the substrate, which may be determined based on actual conditions. For example, the substrate may be a crystalline silicon substrate. This embodiment does not limit the specific type of the substrate. For example, the substrate may be an N-type substrate, or alternatively a P-type substrate. In the embodiment, the first doped polysilicon layer, the second doped polysilicon layer and the substrate use the same type of doping element. The embodiment does not limit the specific doping element. For example, the doping element may be B (boron), P (phosphorus), or Ga (gallium). It should be noted that an appropriate doping element should be selected according to the specific type of the substrate.

It should be noted that, in the present embodiment, the stacked passivation film can be provided on the front surface and/or the rear surface of the substrate. That is, the stacked passivation film and the front electrode may be sequentially provided on the front surface of the substrate, and/or the stacked passivation film and the rear electrode may be sequentially provided on the rear surface of the substrate. When the stacked passivation film and the front electrode are sequentially provided on the front surface of the substrate, the present embodiment does not limit the specific structure of the rear surface of the substrate. When the stacked passivation film and the rear electrode are sequentially provided on the rear surface of the substrate, the present embodiment does not limit the specific structure of the front surface of the substrate. For example, the front surface of the substrate may be sequentially provided with a doped layer and a front electrode. The present embodiment does not limit the specific type of the doped layer, which may be determined based on the specific type of the substrate. For example, when the substrate is an N-type substrate, the doped layer may be a P-type doped layer.

The present embodiment does not limit the specific type of the tunnel layer, as long as chemical passivation can be formed on a surface of the substrate. For example, the tunnel layer may be a tunnel silicon oxide layer. It should be noted that the tunnel silicon oxide layer can be formed by performing high-temperature thermal oxidation on silicon atoms on a surface of the crystalline silicon substrate. It is used to provide full-area chemical passivation to the crystalline silicon substrate and to provide tunnel and/or perforation channels for photogenerated carriers generated in the crystalline silicon substrate to transport to the electrode. The thickness of the tunnel silicon oxide layer does not exceed 2 nm.

It should be noted that the first doped polysilicon layer can enhance the chemical passivation effect of the tunnel silicon oxide layer through the amorphous silicon contained therein. In addition, the bandgap of amorphous silicon is far greater than that of the crystalline silicon substrate (1.12 eV). After doping with group III or group V elements (examples of group III and group V doping elements include B, P, and Ga), the first doped polysilicon layer provides partial field passivation effect for the transport of photogenerated carriers in the crystalline silicon. Furthermore, after doping with group III or group V elements, the resistivity of the first doped polysilicon layer is reduced, thereby also providing a conduction path for photogenerated carriers generated in the crystalline silicon substrate.

The present embodiment does not limit the specific thickness of the first doped polysilicon layer. For example, the thickness of the first doped polysilicon layer 132 may be 20 nm to 40 nm, including the values at both ends.

It should be noted that, since a single thin tunnel layer is insufficient to provide an optimal passivation effect for a crystalline silicon cell, the first doped polysilicon layer is additionally provided herein to further enhance the passivation performance of the crystalline silicon cell. However, if the first doped polysilicon layer is excessively thick, the dopant atoms introduced therein will inevitably introduce an excessive number of foreign dopant atoms, which in turn introduces too many recombination centers, making it unfavorable for reducing the Auger recombination rate of the first doped polysilicon layer. If the first doped polysilicon layer is too thin, it cannot fully exert the passivation effect.

The present embodiment does not limit the specific overall doping concentration of the first doped polysilicon layer. For example, the overall doping concentration of the first doped polysilicon layer may be greater than the overall doping concentration of the substrate; may be lower than the overall doping concentration of the substrate 1; or may be equal to the overall doping concentration of the substrate. It should be noted that when the overall doping concentration of the first doped polysilicon layer is greater than that of the substrate, a surface field passivation effect can be established between the substrate and the first doped polysilicon layer, thereby accelerating the selective extraction of electrons or holes among the photogenerated carriers.

In the present embodiment, the diffusion barrier layer is adjacent to the first doped polysilicon layer corresponding to the non-metallized region, and is used to block a doping element in the second doped polysilicon layer from diffusing into the first doped polysilicon layer. The present embodiment does not limit the specific type of the diffusion barrier layer, as long as it is capable of blocking the diffusion of a doping element into the first doped polysilicon layer. For example, the diffusion barrier layer may be a silicon oxide layer. The silicon oxide layer can be composed of silicon dioxide deposited by CVD (Chemical Vapor Deposition). Specifically, it may be formed by introducing oxygen or a carrier gas containing oxygen into a CVD deposition chamber and allowing oxygen to undergo an oxidation reaction with intrinsic amorphous silicon.

It should be noted that, in the process of manufacturing the TOPCon cell of the present embodiment, when subsequently performing atomic doping on the intrinsic amorphous silicon to form the doped polysilicon layer, the relatively dense crystal structure of silicon dioxide, compared with that of intrinsic amorphous silicon, provides a good interfacial barrier layer for the atomic doping of the intrinsic amorphous silicon, thereby slowing the diffusion of dopant atoms within the silicon dioxide layer serving as the diffusion barrier layer.

It should be noted that the second doped polysilicon layer is formed on a surface of the diffusion barrier layer that is away from the substrate. The second doped polysilicon layer is formed by depositing intrinsic amorphous silicon through CVD and performing doping with doping atoms followed by high-temperature crystallization, which structure provides full-area chemical passivation and field passivation effect for the crystalline silicon substrate. Moreover, after high-concentration doping of the second doped polysilicon layer with group III or group V doping elements, its electrical conductivity is greatly enhanced, thereby providing a conduction pathway for transporting photogenerated carriers generated in the crystalline silicon substrate.

It should be noted that, because the doping elements in the non-metallized region need to diffuse through the diffusion barrier layer into the first doped polysilicon layer, the overall doping concentration of the second doped polysilicon layer is higher than that of the first doped polysilicon layer. The present embodiment does not limit the specific values of the overall doping concentrations of the first or second doped polysilicon layers. For example, the overall doping concentration of the first doped polysilicon layer may be 1E19 cm⁻³ to 3E20 cm⁻³, including the values at both ends; and the overall doping concentration of the second doped polysilicon layer may be 5E20 cm⁻³ to 1E21 cm⁻³, including the values at both ends.

The present embodiment does not limit the specific thickness of the second doped polysilicon layer. For example, the thickness from a surface of the second doped polysilicon layer away from the substrate to a surface of the diffusion barrier layer away from the substrate is 20 nm to 200 nm, including the values at both ends.

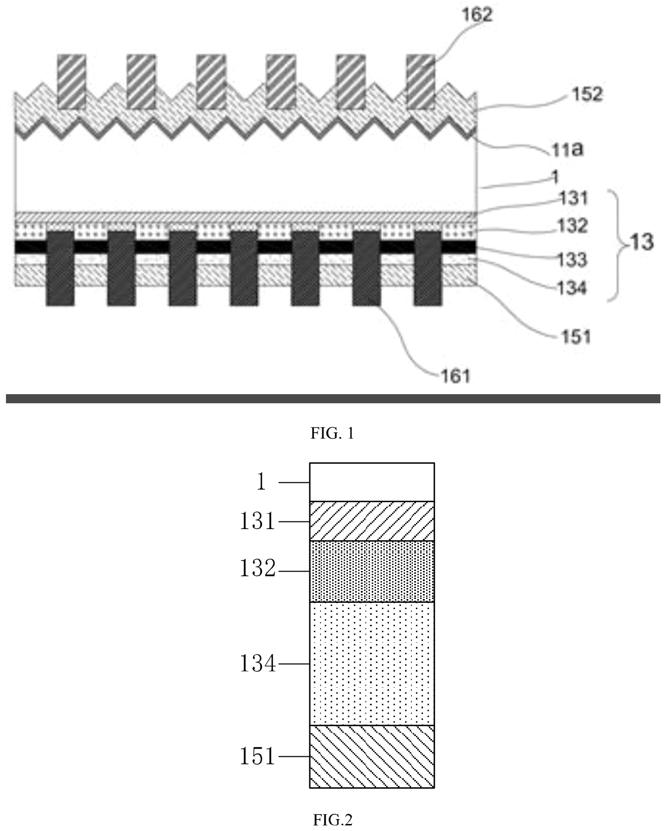

It should be noted that, in the present embodiment, by providing the second doped polysilicon layer, a sufficient etching penetration thickness is provided for the corrosive glass phase in the metallization paste. This prevents the metal electrode material obtained after the sintering of the metallization paste during electrode printing from burning through the tunnel layer. That is, the contact interface of the metal electrode material formed under the etching effect of the glass phase in the metallization paste may be located in the second doped polysilicon layer, in the diffusion barrier layer, or in the first doped polysilicon layer. As shown in Fig. 1, when the electrode forms an ohmic contact with the first doped polysilicon layer, the differentiated doping concentration formed by the doping elements in the first doped polysilicon layer allows the electrode to form a good ohmic contact with the first doped polysilicon layer having a higher dopant concentration. Meanwhile, the non-metallized region corresponding to the first doped polysilicon layer has a lower phosphorus atom doping concentration and thus provides a better passivation effect, which improves the conversion efficiency of the cell. When the electrode forms an ohmic contact with the second doped polysilicon layer, electrons tend to be transported along the path of the second doped polysilicon layer having better electrical conductivity, thereby reducing the transport resistance loss of electrons. In addition, the differentiated doping concentration formed by the doping element in the first doped polysilicon layer not only ensures the passivation effect of the first doped polysilicon layer but also helps reduce the doping concentration of the doping elements therein, thus reducing the Auger recombination rate caused by atomic doping and increasing the conversion efficiency of the cell.

When the stacked passivation film is disposed on the back surface of the substrate, further, to enhance the passivation effect, a rear passivation layer may be provided on a surface of the stacked passivation film away from the substrate. The electrode penetrates through the rear passivation layer and is in contact with the stacked passivation film. The present embodiment does not limit the specific type of the rear passivation layer. For example, the rear passivation layer may comprise at least one of a SiNₓ film, a SiOₓN_{y} film, an Al₂O₃/SiNₓ stacked film, and a SiOₓN_{y}/SiNₓ stacked film.

Based on the above embodiments, the present disclosure adopts a double-layer doped polysilicon layer, which is capable of avoiding penetration through the doped polysilicon layers during the printed-electrode sintering process, ensuring that the thickness of the inner doped polysilicon layer can achieve a good passivation effect. Further, a diffusion barrier layer, corresponding to the non-metallized region, is added between the two doped polysilicon layers, and is used to block diffusion of a doping element of the outer doped polysilicon layer, thereby the inner doped polysilicon layer exhibits a high doping concentration in the metallized region and a low doping concentration in the non-metallized region. Consequently, the overall doping concentration of the inner doped polysilicon layer is reduced, thereby the Auger recombination rate is reduced. The doping concentration of the outer doped polysilicon layer is higher than that of the inner doped polysilicon layer. The inner doped polysilicon layer exhibits a high doping concentration in the metallized region, thereby ensuring the achievement of a good ohmic contact.

Reference is made to FIG. 1, which illustrates a structure of a TOPCon cell provided in an embodiment of the present disclosure. The TOPCon cell may comprise: a substrate 1; a doped layer 11a, a front passivation layer 152, and a front electrode 162 sequentially provided on the front surface of the substrate 1; and a stacked passivation film 13, a rear passivation layer 151, and a rear electrode 161 sequentially provided on the rear surface of the substrate 1.

The stacked passivation film 13 comprises a tunnel silicon oxide layer 131, a first doped polysilicon layer 132, a diffusion barrier layer 133, and a second doped polysilicon layer 134, sequentially arranged away from the substrate 1.

A metallized region and a non-metallized region are provided on a surface of the substrate 1 facing the rear electrode 161. The diffusion barrier layer 133 corresponds to the non-metallized region and is used to block a doping element in the second doped polysilicon layer 134 from diffusing into the first doped polysilicon layer 132. As a result, the dopant concentration of the first doped polysilicon layer 132 in the non-metallized region is lower than that in the metallized region.

The surface of rear electrode 161, adjacent to the substrate 1, is located at the first doped polysilicon layer 132, such that the rear electrode 161 forms an ohmic contact with the first doped polysilicon layer 132.

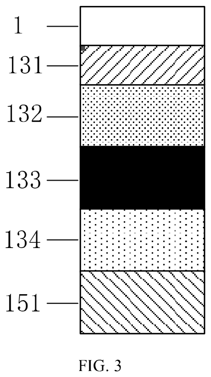

It should be noted that, along the vertical direction of the substrate 1, the metallized region includes, from inside to outside as shown in Fig. 2: the tunnel silicon oxide layer 131, the first doped polysilicon layer 132, and the second doped polysilicon layer 134. As shown in Fig. 3, the non-metallized region includes, from inside to outside: the tunnel silicon oxide layer 131, the first doped polysilicon layer 132, the diffusion barrier layer 133, and the second doped polysilicon layer 134. The diffusion barrier layer 133 corresponds to the non-metallized region. During doping of the stacked passivation film 13, the diffusion barrier layer 133 blocks the diffusion of a doping element, thereby forming a first doped polysilicon layer 132 with a lower dopant concentration in the non-metallized region, whereas the first doped polysilicon layer 132, corresponding to the metallized region, exhibits a relatively high doping concentration because no diffusion barrier layer 133 is present to impede doping element diffusion. Consequently, a differentiated doping concentration is formed within the first doped polysilicon layer 132.

Based on the above embodiments, the present disclosure adopts a double-layer doped polysilicon structure, which ensures that the thickness of the inner doped polysilicon layer can achieve a good passivation effect. Further, a diffusion barrier layer, corresponding to the non-metallized region, is added between the two doped polysilicon layers, and is used to block diffusion of a doping element of the outer doped polysilicon layer, thereby the inner doped polysilicon layer exhibits a high doping concentration in the metallized region and a low doping concentration in the non-metallized region. Consequently, the overall doping concentration of the inner doped polysilicon layer is reduced, thereby the Auger recombination rate is reduced. Through the front passivation layer 152 and the rear passivation layer 151, in combination with the stacked passivation film 13, the passivation effect is further enhanced.

The embodiments of the present disclosure further provide a method for manufacturing a TOPCon cell comprises steps of:
forming a stacked passivation film layer on a surface of a side of a substrate; wherein the stacked passivation film comprises a tunnel layer, a first doped polysilicon layer, a diffusion barrier layer, and a second doped polysilicon layer sequentially arranged in a direction away from the substrate; wherein a metallized region and a non-metallized region are provided on a surface of a side of the substrate corresponding to the stacked passivation film layer, the diffusion barrier layer corresponds to the non-metallized region and is used to block diffusion of a doping element in the second doped polysilicon layer into the first doped polysilicon layer, such that doping concentration of the first doped polysilicon layer in the non-metallized region is lower than doping concentration of the first doped polysilicon layer in the metallized region.

The present embodiment does not limit any particular method for forming the stacked passivation film, as long as the stacked passivation film can be formed on a surface of the substrate. For example, the stacked passivation film may be formed by the following two methods:
(1) depositing a tunnel layer on a surface of the substrate; depositing a first intrinsic amorphous silicon layer on a surface of the tunnel layer; forming a diffusion barrier layer on a surface of the first intrinsic amorphous silicon layer corresponding to the non-metallized region; depositing a second intrinsic amorphous silicon layer on a surface of the first intrinsic amorphous silicon layer corresponding to the metallized region and on a surface of the diffusion barrier layer; and performing diffusion of a doping element, wherein in the metallized region, the doping element sequentially diffuses into the second intrinsic amorphous silicon layer and the first intrinsic amorphous silicon layer, and in the non-metallized region, the doping element sequentially diffuses into the second intrinsic amorphous silicon layer, the diffusion barrier layer, and the first intrinsic amorphous silicon layer, thereby converting the second intrinsic amorphous silicon layer into the second doped polysilicon layer and the first intrinsic amorphous silicon layer into the first doped polysilicon layer.

Further, to avoid an excessively low dopant concentration of the first doped polysilicon layer, in the present embodiment, after the first intrinsic amorphous silicon layer is deposited on a surface of the tunnel layer, a light doping may be performed on the first intrinsic amorphous silicon layer, so as to adjust the carrier transport properties of the first doped polysilicon layer.

(2) depositing the tunnel layer on a surface of the substrate; depositing the first doped polysilicon layer on a surface of the tunnel layer by in-situ doping; forming the diffusion barrier layer on a surface of the first doped polysilicon layer corresponding to the non-metallized region; depositing the second doped polysilicon layer on a surface of the first doped polysilicon layer corresponding to the metallized region and on a surface of the diffusion barrier layer; and performing annealing on the first doped polysilicon layer and the second doped polysilicon layer.

It should be noted that, in method (1), the first doped polysilicon layer and the second doped polysilicon layer are formed by impurity diffusion, whereas in method (2), the first doped polysilicon layer and the second doped polysilicon layer are formed by in-situ doping and subsequent annealing.

It should also be noted that, in the present embodiment, the stacked passivation film may be provided on the front surface and/or the rear surface of the substrate. That is, the front surface of the substrate may be sequentially provided with the stacked passivation film and the front electrode, and/or the rear surface of the substrate may be sequentially provided with the stacked passivation film and the rear electrode. When the front surface of the substrate is sequentially provided with the stacked passivation film and the front electrode, the present embodiment does not limit the specific structure of the rear surface of the substrate. When the rear surface of the substrate is sequentially provided with the stacked passivation film and the rear electrode, the present embodiment does not limit the specific structure of the front surface of the substrate. For example, the front surface of the substrate may be sequentially provided with a doped layer and a front electrode.

When the rear surface of the substrate is sequentially provided with the stacked passivation film and the rear electrode, and the front surface of the substrate is sequentially provided with the doped layer and the front electrode, the manufacture method of the present embodiment may comprise steps of:
forming a doped layer on a front surface of the substrate;
after the doped layer is formed, forming a stacked passivation film on a rear surface of the substrate; wherein the stacked passivation film comprises a tunnel layer, a first doped polysilicon layer, a diffusion barrier layer, and a second doped polysilicon layer sequentially arranged in a direction away from the substrate; wherein a metallized region and a non-metallized region are provided on the surface of the substrate corresponding to the stacked passivation film, the diffusion barrier layer corresponds to the non-metallized region and is used to block diffusion of a doping element in the second doped polysilicon layer from into the first doped polysilicon layer, such that the doping concentration of the first doped polysilicon layer in the non-metallized region is lower than the doping concentration of the first doped polysilicon layer in the metallized region;
printing a rear electrode on the rear surface of the stacked passivation layer away from the substrate, and printing a front electrode on the front surface of the doped layer away from the substrate, thereby obtaining the TOPCon cell.

Based on the above embodiments, the TOPCon cell manufactured according to the present disclosure adopts a double-layer doped polysilicon structure, which ensures that the thickness of the inner doped polysilicon layer can achieve a good passivation effect. Further, a diffusion barrier layer, corresponding to the non-metallized region, is added between the two doped polysilicon layers, and is used to block diffusion of a doping element of the outer doped polysilicon layer, thereby the inner doped polysilicon layer exhibits a high doping concentration in the metallized region and a low doping concentration in the non-metallized region. Consequently, the overall doping concentration of the inner doped polysilicon layer is reduced, thereby the Auger recombination rate is reduced. The doping concentration of the outer doped polysilicon layer is higher than that of the inner doped polysilicon layer. The inner doped polysilicon layer exhibits a high doping concentration in the metallized region, thereby ensuring the achievement of a good ohmic contact.

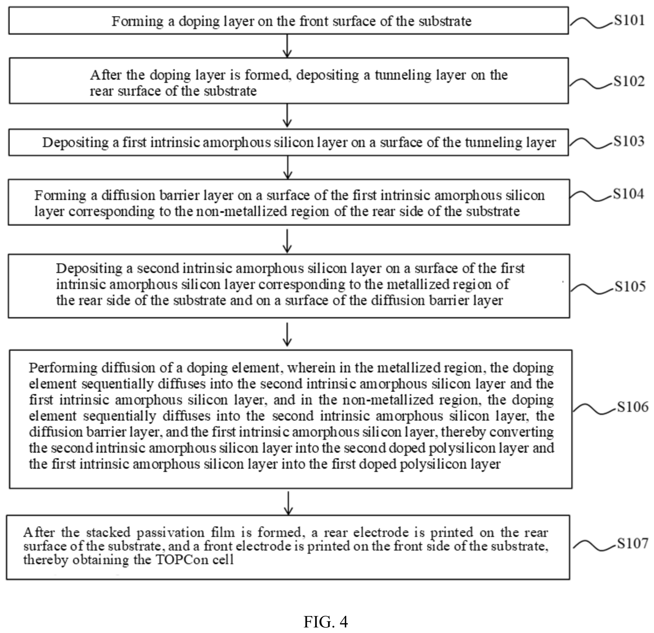

Reference is made to FIG. 4, which is a flowchart of a method for manufacturing a TOPCon cell according to an embodiment of the present disclosure. The method may comprise:
S101: forming a doped layer on the front surface of the substrate.

The present embodiment does not limit the specific method for forming the doped layer and the method may be determined based on the particular type of doped layer. For example, when the doped layer is a P-type doped layer, the doped layer may be formed on the front surface of the substrate by performing boron diffusion on the substrate. It should be noted that during the diffusion process, a BSG (BoroSilicate Glass) layer may be formed on both surfaces of the substrate. Further, in the present embodiment after step S101, the BSG layer on the rear surface of the substrate can be removed. The present embodiment does not limit the specific method for removing the BSG layer, as long as the BSG layer can be removed. For example, the BSG layer on the front surface and rear surface of the substrate may be removed by a chain-cleaning process.

Further, to enhance the light-trapping performance of the substrate, the substrate may be subjected to double-sided alkaline texturing prior to step S101 to obtain a substrate having a pyramidal textured surface structure. It should be noted that after the double-sided alkaline texturing on the substrate and after the doped layer is prepared on the front surface of the substrate, the rear surface of the substrate should be polished to obtain a relatively flat rear surface.

S102: after the doped layer is prepared, depositing a tunnel layer on the rear surface of the substrate.

The present embodiment does not limit the specific method for depositing the tunnel layer and the method may be determined based on the specific type of tunnel layer. For example, when the tunnel layer is a tunnel silicon oxide layer, oxygen or an oxygen-containing carrier gas (including but not limited to nitrogen or inert gases such as argon or helium) may be introduced into a CVD deposition chamber. The oxygen undergoes a thermal oxidation reaction with silicon atoms on the rear surface of the crystalline silicon substrate to form the tunnel silicon oxide layer.

S103: depositing a first intrinsic amorphous silicon layer on a surface of the tunnel layer.

The present embodiment does not limit the specific method for depositing the first intrinsic amorphous silicon layer. For example, a mixed gas containing a silicon source gas and/or a carrier gas carrying the silicon source gas may be introduced into a CVD deposition chamber. The silicon source gas deposits on a surface of the tunnel layer at a high temperature to form the first intrinsic amorphous silicon layer.

S104: forming a diffusion barrier layer on a surface of the first intrinsic amorphous silicon layer corresponding to the non-metalized region.

The present embodiment does not limit the specific method for forming the diffusion barrier layer. For example, oxygen or an oxygen-containing carrier gas may be introduced into a CVD deposition chamber, and oxygen undergoes an oxidation reaction with the first intrinsic amorphous silicon layer to form the diffusion barrier layer.

It should be noted that, since oxygen directly contacts silicon atoms in the first intrinsic amorphous silicon layer and undergoes an oxidation reaction to form silicon oxide (SiₓO_{y}), the Si-O crystal structure of the silicon oxide (SiₓO_{y}) formed by oxidizing the first intrinsic amorphous silicon layer is relatively loose compared with the tunnel silicon oxide layer formed by thermally oxidizing a crystalline silicon substrate, thereby providing an appropriate barrier effect for subsequent doping element diffusion.

The metalized region and the non-metalized region require different doping element concentrations. If patterning is performed during formation of the diffusion barrier layer, and the non-metalized region is blocked with the diffusion barrier layer while the metalized region is not blocked with the diffusion barrier layer, different dopant concentrations can be determined accordingly. After the diffusion barrier layer is obtained by CVD, a patterning process is further performed on the diffusion barrier layer, so as to form a diffusion barrier layer on a surface of the first intrinsic amorphous silicon layer corresponding to the non-metalized region. The patterning process comprises steps of:

forming the diffusion barrier layer on the rear surface of the substrate; after the diffusion barrier layer is formed, forming a patterned mask film corresponding to the non-metalized region on the rear surface of the substrate; after the patterned mask is formed, placing the substrate into an acid or alkaline solution to remove portions of the diffusion barrier layer not covered by the patterned mask through etching; after the diffusion barrier layer is removed, cleaning to remove the patterned mask. The present embodiment does not limit the specific method for forming the patterned mask. For example, the patterned mask corresponding to the non-metalized region may be formed on the rear surface of the substrate by screen printing, laser transfer, or photolithography. When screen printing is adopted, a paste resistant to HF (hydrofluoric acid) etching or an acid and alkali resistant wax may be printed on the rear surface of the substrate to form the patterned mask corresponding to the non-metalized region.

S105: depositing a second intrinsic amorphous silicon layer on a surface of the first intrinsic amorphous silicon layer corresponding to the metallized region and on a surface of the diffusion barrier layer.

The present embodiment does not limit the specific method for depositing the second intrinsic amorphous silicon layer. For example, a silicon source gas and/or a mixed gas of a carrier gas containing the silicon source gas may be introduced into a CVD deposition chamber. Under a high-temperature condition, the silicon source gas deposits on the surface of the first intrinsic amorphous silicon layer corresponding to the metalized region and on a surface of the diffusion barrier layer to form the second intrinsic amorphous silicon layer.

S106: performing diffusion of a doping element, wherein in the metallized region, doping elements sequentially diffuse into the second intrinsic amorphous silicon layer and the first intrinsic amorphous silicon layer, and in the non-metallized region, the doping elements sequentially diffuse into the second intrinsic amorphous silicon layer, the diffusion barrier layer, and the first intrinsic amorphous silicon layer, thereby converting the second intrinsic amorphous silicon layer into the second doped polysilicon layer and the first intrinsic amorphous silicon layer into the first doped polysilicon layer.

The present embodiment does not limit the specific method for performing dopant diffusion, as long as the doping element can diffuse toward the substrate and sequentially diffuse into the second intrinsic amorphous silicon layer, the diffusion barrier layer, and the first intrinsic amorphous silicon layer. For example, a doping element gas source and oxygen may be introduced into a CVD deposition chamber.

It should be noted that, during the diffusion process, a wrap-around PSG (Phospho Silicate Glass) layer may be formed on the edge of the front surface of the substrate 1. Furthermore, in the present embodiment, after step S106, the wrap-around PSG layer on the front surface of the substrate may be removed.

Further, to enhance the passivation effect, in the present embodiment after step S106, a front passivation layer may be deposited on the front surface of the substrate 1, and a rear passivation layer may be printed on the rear surface of the substrate 1.

S107: printing a rear electrode on the rear surface of the stacked passivation layer away from the substrate, and printing a front electrode on the front surface of the doped layer away from the substrate, thereby obtaining the TOPCon cell.

It should be noted that the front electrode or the rear electrode is normally formed by printing a metallized paste.

Based on the above embodiments, the TOPCon cell manufactured according to the present disclosure adopts a double-layer doped polysilicon structure, which ensures that the thickness of the inner doped polysilicon layer can achieve a good passivation effect. Further, a diffusion barrier layer, corresponding to the non-metallized region, is added between the two doped polysilicon layers, and is used to block diffusion of a doping element of the outer doped polysilicon layer, thereby the inner doped polysilicon layer exhibits a high doping concentration in the metallized region and a low doping concentration in the non-metallized region. Consequently, the overall doping concentration of the inner doped polysilicon layer is reduced, thereby the Auger recombination rate is reduced. The doping concentration of the outer doped polysilicon layer is higher than that of the inner doped polysilicon layer. The inner doped polysilicon layer exhibits a high doping concentration in the metallized region, thereby ensuring the achievement of a good ohmic contact.

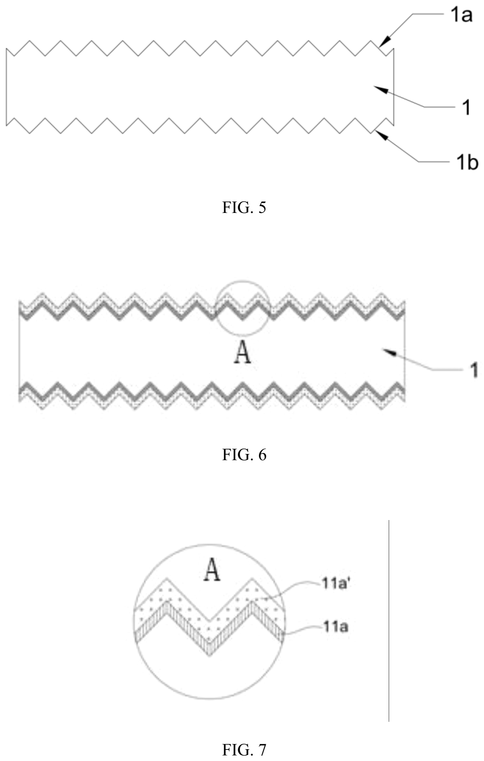

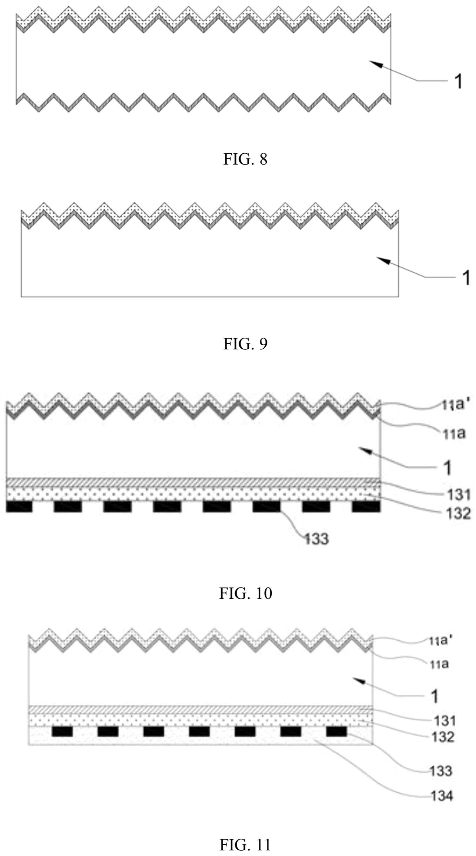

The manufacture process of the above TOPCon cell is described below in conjunction with specific examples, referring to FIGs. 5 to 14. In the present example, the substrate 1 was an N-type crystalline silicon substrate. The process was as follows:
Step 1: preparing a single surface crystalline silicon substrate 1 having a polished surface.
1. As shown in FIG. 5, double-sided alkaline texturing was performed on the crystalline silicon substrate 1 to obtain a crystalline silicon substrate 1 having a pyramidal textured surface structure. The light-receiving surface of the crystalline silicon substrate 1 corresponded to the first surface 1a, and the corresponding opposite surface was the second surface 1b at the rear surface.
2. As shown in FIG. 6 and FIG. 7, a PN junction was formed by performing boron diffusion on the crystalline silicon substrate 1 having the pyramidal textured surface structure. A P-type doped layer 11a (for forming the PN junction) and a BSG layer 11a' were formed on the first surface 1a of the crystalline silicon substrate 1. Likewise, a P-type doped layer and a BSG layer were also formed on the second surface 1b of the crystalline silicon substrate 1.
3. As shown in FIG. 8, the BSG layer on the second surface 1b of the crystalline silicon substrate 1 was removed by chain cleaning.
4. As shown in FIG. 9, the second surface 1b of the crystalline silicon substrate 1 was polished by chain cleaning to obtain a relatively planar second surface 1b.

Step 2: preparing the stacked passivation film 13 on the second surface 1b of the crystalline silicon substrate 1

The silicon wafer was placed into a CVD deposition chamber to deposit the stacked passivation film 13.

In a first stage, oxygen or a carrier gas containing oxygen (including but not limited to nitrogen or inert gases such as argon or helium) was introduced into the CVD deposition chamber. A thermal oxidation reaction occurred between oxygen and silicon atoms on the rear surface of the crystalline silicon substrate 1, thereby forming a tunnel silicon oxide layer 131.

In a second stage, a silicon source gas or a mixed gas of a carrier gas containing a silicon source gas a was introduced into the CVD deposition chamber. Under a high-temperature condition, the silicon source gas deposited on a surface of the tunnel silicon oxide layer 131 to obtain the first intrinsic amorphous silicon layer 132. The first intrinsic amorphous silicon layer 132 had a first thickness W1 of 20 nm to 40 nm (including the values at both ends). A doped polycrystalline silicon layer having a minimum thickness of 20 nm in combination with approximately 1.5 nm of the tunnel silicon oxide layer 131 provided a good passivation level for the surface of the N-type crystalline silicon substrate 1.

In a third stage, oxygen or a carrier gas containing oxygen was introduced into the CVD deposition chamber. Oxygen directly contacted silicon atoms in the first intrinsic amorphous silicon layer 132 and reacted therewith, thereby forming a diffusion barrier layer 133 composed of silicon oxide layer. Since the silicon oxide SiₓO_{y} formed by oxidizing the first intrinsic amorphous silicon layer 132 had a relatively loose Si-O crystal structure compared with the tunnel silicon oxide layer 131 prepared by thermal oxidation on the crystalline silicon substrate 1, it provided an appropriate barrier effect for the subsequent diffusion of a doping element.

Metalized regions and non-metalized regions required different doping element concentrations. If patterning was performed during formation of the diffusion barrier layer 133, the non-metalized region was blocked with the diffusion barrier layer 133 while the metalized region was not blocked with the diffusion barrier layer 133, different doping element concentrations of non-metalized region and metalized region could be determined accordingly. After the diffusion barrier layer 133 was obtained by CVD, the diffusion barrier layer 133, an additional patterning process was performed on the diffusion barrier layer 133, such that the diffusion barrier layer 133 was formed on a surface of the first intrinsic amorphous silicon layer 132 corresponding to the non-metalized region. The patterning procedure comprised:
after forming the diffusion barrier layer 133 on the rear surface of the crystalline silicon substrate 1, a patterned mask corresponding to the non-metalized region pattern was formed. The patterned mask could be formed by screen printing, laser transfer, photolithography, or other methods.

As shown in Fig. 10, in one embodiment, the patterned mask may be formed by printing an HF-resistant slurry, paste or ink, or by applying an acid and alkali resistant wax. The crystalline silicon substrate was placed into an HF solution, wherein the portion of the diffusion barrier layer 133 not protected by the patterned mask was removed by HF. The patterned mask was subsequently removed by sequential cleaning, resulting in a selectively patterned diffusion barrier layer 133 on the rear surface of the crystalline silicon substrate 1.

In a fourth stage, as shown in Fig. 11, a mixed gas of a silicon source gas and a carrier gas containing a silicon source gas was introduced into the CVD deposition chamber. Under a high-temperature condition, a second intrinsic amorphous silicon layer 134 was obtained by depositing the silicon source gas on a surface of the first intrinsic amorphous silicon layer 132 and the rear surface of the substrate 1 corresponding to the metallized region, and on a surface of the diffusion barrier layer 133. The second intrinsic amorphous silicon layer 134 had a second thickness of 20 nm to 200 nm (including the values at both ends).

Step 3: diffusing doping elements into the rear surface of the crystalline silicon substrate 1

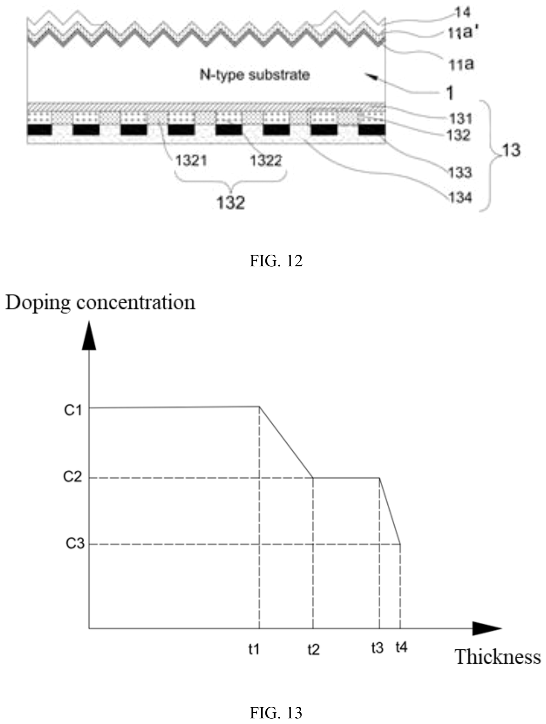

As shown in Fig. 12, a dopant gas source of POCl₃ (phosphoryl chloride) and oxygen were introduced into the CVD deposition chamber. Oxygen reacted with POCl₃ to form P₂O₅ (phosphorus pentoxide). Under a high-temperature condition, phosphorus atoms in the P₂O₅ continuously diffused toward the crystalline silicon substrate 1. The phosphorus atoms successively diffused into the second intrinsic amorphous silicon layer 134, the diffusion barrier layer 133, the first intrinsic amorphous silicon layer 132, and the tunnel silicon oxide layer 131. Through the annealing process associated with phosphorus diffusion, a second doped polycrystalline silicon layer 134 containing doped phosphorus atoms, the diffusion barrier layer 133, a first doped polycrystalline silicon layer 132, the tunnel silicon oxide layer 131, and a PSG layer (not shown in the figure) were formed on the rear surface of the crystalline silicon substrate 1, while a wrap-around PSG layer 14 was formed at the edge of the front surface of the crystalline silicon substrate 1.

Since the diffusion barrier layer 133 in the non-metalized region blocked the diffusion of phosphorus atoms, differentiated local dopant concentrations were formed in the first intrinsic amorphous silicon layer 132 during phosphorus atom diffusion. That is, the first doped polycrystalline silicon layer 132 comprised a first high passivation silicon-containing layer 1321 corresponding to a higher phosphorus atom diffusion concentration, and a first low passivation silicon-containing layer 1322 corresponding to a lower phosphorus diffusion concentration. It should be noted that phosphorus atom diffusion in the first intrinsic amorphous silicon layer was omnidirectional. However, since the horizontal length of the diffusion barrier layer 133 was far greater than its vertical thickness, the horizontal diffusion of phosphorus atom during a short diffusion period could be neglected. Therefore, phosphorus atom diffusion in the first intrinsic amorphous silicon layer 132 could be physically approximated as diffusion occurring only in the vertical direction.

The second doped polycrystalline silicon layer 134 had a second phosphorus atom doping concentration C1. The diffusion barrier layer 133 was a silicon dioxide layer with a blocking effect against phosphorus diffusion, therefore phosphorus diffusion was limited, and thus the phosphorus atom doping concentration was lower than the second phosphorus atom doping concentration C1.

The first doped polycrystalline silicon layer 132 had a first phosphorus atom doping concentration C2. Since phosphorus atoms needed to pass through the diffusion barrier layer 133 to reach the first doped polycrystalline silicon layer 132, the first phosphorus atom doping concentration C2 was lower than the phosphorus atom doping concentration in the diffusion barrier layer 133.

As shown in Fig. 13, the thicknesses t1, t2, t3, and t4 were 90 nm, 95 nm, 120 nm, and 125 nm, respectively. The direction of the thickness corresponding to the X-axis was defined as extending from the surface of the second doped polycrystalline silicon layer 134 serving as a datum level toward the crystalline silicon substrate 1. Specifically, thickness t1 corresponded to the second thickness W2 of the second doped polycrystalline silicon layer 134, thickness t2 corresponded to the thickness between the diffusion barrier layer 133 and the datum level of the second doped polycrystalline silicon layer 134, thickness t3 corresponded to the thickness between the first doped polycrystalline silicon layer 132 and the datum level of the second doped polycrystalline silicon layer 134, and thickness t4 corresponded to the thickness between the tunnel silicon oxide and the datum level of the second doped polycrystalline silicon layer 134.

The Y-axis corresponded to the phosphorus atom doping concentration in each layer of the stacked passivation film 13. Specifically, the second doped polycrystalline silicon layer 134 had a second phosphorus atom doping concentration C1, the first doped polycrystalline silicon layer 132 had a first phosphorus atom doping concentration C2, and the phosphorus atom doping concentration at the interface between the crystalline silicon substrate 1 and the tunnel silicon oxide layer 131 was C3 (atoms/cm³) (C1, C2, and C3 were 5E20 cm⁻³, 3E20 cm⁻³, and 6E19 cm⁻³, respectively).

Since the first thickness W1 and the second thickness W2 were both at the nanometer scale, and the phosphorus diffusion rate at a high temperature compared with the diffusion rate within nanoscale of intrinsic amorphous silicon layers was taken into consideration, the phosphorus concentration within the first thickness W1 and the second thickness W2 could be considered approximately equal.

However, the presence of the diffusion barrier layer 133 will reduce the phosphorus diffusion concentration from the second intrinsic amorphous silicon layer 134 into the first intrinsic amorphous silicon layer 132, particularly when the silicon dioxide layer was formed by using the first intrinsic amorphous silicon layer 132 after high-temperature annealing.

The second phosphorus atom doping concentration C1 in the second doped polycrystalline silicon layer 134 was 5E20 cm⁻³ to 1E21 cm⁻³ (including the values at both ends). The relatively high doping concentration of the second doped polycrystalline silicon layer 134 provided an ideal ohmic contact for the rear electrode 161, significantly reducing the transport resistance loss of photogenerated carriers.

The first phosphorus atom doping concentration C2 in the first doped polycrystalline silicon layer 132 was 1E19 cm⁻³ to 3E20 cm⁻³ (including the values at both ends). The lower doping concentration of the first doped polycrystalline silicon layer 132 enabled chemical passivation for the solar cell. Since the doping concentration was low, it further reduced Auger recombination in the TOPCon solar cell.

Step 4: forming passivation films on the front and rear surfaces of the crystalline silicon substrate 1 and manufacturing electrodes to obtain the solar cell structure shown in FIG. 1.

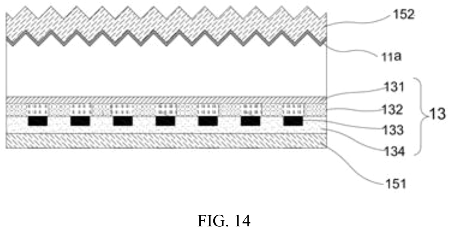

As shown in Fig. 14, a rear passivation film was formed on the rear surface of the crystalline silicon substrate 1, and a front passivation film was formed on the front surface of the crystalline silicon substrate 1. Subsequently, metallized pastes were printed on both the front and rear surfaces of the crystalline silicon substrate 1 to obtain the TOPCon solar cell structure shown in Fig. 1.

Specific embodiments are applied herein to illustrate the principles and implementation of the present disclosure. The embodiments are arranged in a progressive manner, where each embodiment emphasized the differences relative to the others, and the identical or similar parts among the embodiments can be referred to interchangeably. The above descriptions of the embodiments are provided merely to assist in understanding the method and core concepts of the present disclosure. For a person skilled in the art, various modifications and improvements can still be made without departing from the principles of the present disclosure, and these modifications and improvements also fall within the scope of protection defined by the claims of the present disclosure.

It should also be noted that relational terms such as "first" and "second" are used merely to distinguish one entity or operation from another, and do not necessarily imply any actual relationship or sequence between such entities or operations. Furthermore, the terms "comprise," "comprising," or any other variations thereof are intended to cover non-exclusive inclusion. Thus, a process, method, article, or device that comprises a list of elements comprises not only those elements, but may also comprise other elements not expressly listed, or elements inherent to such process, method, article, or device. Without further limitations, an element defined by the phrase "comprise a ..." does not exclude the presence of additional, identical elements in the process, method, article, or device that comprises the element.

## Claims

1. A TOPCon cell comprising a substrate; wherein a stacked passivation film and an electrode are provided on a surface of a side of the substrate;
wherein the stacked passivation film comprises a tunnel layer, a first doped polysilicon layer, a diffusion barrier layer, and a second doped polysilicon layer sequentially arranged in a direction away from the substrate;
wherein a metallized region and a non-metallized region are provided on a surface of a side of the substrate facing the electrode, the diffusion barrier layer corresponds to the non-metallized region and is used to block diffusion of a doping element in the second doped polysilicon layer into the first doped polysilicon layer, such that doping concentration of the first doped polysilicon layer in the non-metallized region is lower than doping concentration of the first doped polysilicon layer in the metallized region.

2. The TOPCon cell according to claim 1, wherein the diffusion barrier layer is a silicon oxide layer.

3. The TOPCon cell according to claim 1, wherein the stacked passivation film is provided on the rear surface of the substrate, the first doped polysilicon layer and the second doped polysilicon layer adopt doping elements of the same type as the substrate, an overall doping concentration of the first doped polysilicon layer is greater than that of the substrate, and an overall doping concentration of the second doped polysilicon layer is greater than that of the first doped polysilicon layer.

4. The TOPCon cell according to claim 3, wherein a rear passivation layer is provided on a surface of a side of the stacked passivation film away from the substrate, and the electrode passes through the rear passivation layer and is in contact with the stacked passivation film; wherein the rear passivation layer comprises at least one of SiNₓ film, SiOₓN_{y} film, Al₂O₃/SiNₓ stacked film, and SiOₓN_{y}/SiNₓ stacked film.

5. The TOPCon cell according to claim 1, wherein the first doped polysilicon layer has a thickness of 20 nm to 40 nm, including the values at both ends;
wherein the thickness from a surface of the second doped polysilicon layer away from the substrate to a surface of the diffusion barrier layer away from the substrate is 20 nm to 200 nm, including the values at both ends.

6. The TOPCon cell according to claim 1, wherein the first doped polysilicon layer has an overall doping concentration of 1E19 cm⁻³ to 3E20 cm⁻³, including the values at both ends;
and the second doped polysilicon layer has an overall doping concentration of 5E20 cm⁻³ to 1E21 cm⁻³, including the values at both ends.

7. A method for manufacturing a TOPCon cell comprising steps of:
forming a stacked passivation film layer on a surface of a side of a substrate; wherein the stacked passivation film comprises a tunnel layer, a first doped polysilicon layer, a diffusion barrier layer, and a second doped polysilicon layer sequentially arranged in a direction away from the substrate; wherein a metallized region and a non-metallized region are provided on a surface of a side of the substrate corresponding to the stacked passivation film layer, the diffusion barrier layer corresponds to the non-metallized region and is used to block diffusion of a doping element in the second doped polysilicon layer into the first doped polysilicon layer, such that doping concentration of the first doped polysilicon layer in the non-metallized region is lower than doping concentration of the first doped polysilicon layer in the metallized region.

8. The TOPCon cell according to claim 7, wherein step of forming the stacked passivation film layer on a surface of a side of the substrate comprises:
depositing a tunnel layer on a surface of the substrate;
depositing a first intrinsic amorphous silicon layer on a surface of the tunnel layer;
forming a diffusion barrier layer on a surface of the first intrinsic amorphous silicon layer corresponding to the non-metallized region;
depositing a second intrinsic amorphous silicon layer on a surface of the first intrinsic amorphous silicon layer corresponding to the metallized region and on a surface of the diffusion barrier layer; and
performing diffusion of a doping element, wherein in the metallized region, the doping element sequentially diffuses into the second intrinsic amorphous silicon layer and the first intrinsic amorphous silicon layer, and in the non-metallized region, the doping element sequentially diffuses into the second intrinsic amorphous silicon layer, the diffusion barrier layer, and the first intrinsic amorphous silicon layer, thereby converting the second intrinsic amorphous silicon layer into the second doped polysilicon layer and the first intrinsic amorphous silicon layer into the first doped polysilicon layer.

9. The TOPCon cell according to claim 8, wherein, after depositing the first intrinsic amorphous silicon layer on a surface of the tunnel layer, the method further comprises:
performing a light doping on the first intrinsic amorphous silicon layer.

10. The TOPCon cell according to claim 7, wherein the step of forming a stacked passivation film layer on a surface of a side of a substrate comprises:
depositing the tunnel layer on a surface of the substrate;
depositing the first doped polysilicon layer on a surface of the tunnel layer by in-situ doping;
forming the diffusion barrier layer on a surface of the first doped polysilicon layer corresponding to the non-metallized region;
depositing the second doped polysilicon layer on a surface of the first doped polysilicon layer corresponding to the metallized region and on a surface of the diffusion barrier layer; and
performing annealing on the first doped polysilicon layer and the second doped polysilicon layer.
